# EUROPEAN PATENT SPECIFICATION

(11) **EP 0 905 873 B1**
(45) Date of publication and mention of the grant of the patent: **06.11.2002**
(21) Application number: 98202840.9
(22) Date of filing: 25.08.1998
(51) Int. Cl.: H03K 17/0814, H02M 5/293

(54) **Controlled diode or body diode recovery circuit**
Gesteuerte Dioden- oder Körperdiodenrückgewinnungsschaltung
Circuit de récupération commandé pour diode ou diode de corps

(30) Priority: 25.09.1997 FI 973783; 05.02.1998 FI 980259
(43) Date of publication of application: 31.03.1999
(60) Divisional application: 02010727.2
(73) Proprietor: Helvar Oy Ab, 00380 Helsinki (FI)
(72) Inventor: Wade, Scott, Sevenoaks, Kent, TN15 6EJ (GB)
(74) Representative: LEITZINGER OY

(56) References cited:
- EP-A- 0 351 144
- GB-A- 2 045 549
- GB-A- 2 301 239
- US-A- 5 202 820
- PATENT ABSTRACTS OF JAPAN vol. 1997, no. 08, 29 August 1997 (1997-08-29) & JP 09 103073 A (FUJITSU DENSO LTD;FUJITSU LTD), 15 April 1997 (1997-04-15)

## Description

The invention relates to a controlled diode recovery circuit (C.D.R. circuit) which is connected in series with the diode to be recovered, called main diode in the following, the circuit including a saturable inductor in series with the main diode, and in parallel with the saturable inductor there is a series combination of a second inductor and a second diode, the second inductor being dimensioned for a controlled rate of increase in reverse recovery current of said main diode, and the second diode having its forward direction opposite to the forward direction of the main diode for allowing the flow of the reverse recovery current of the main diode.

The invention relates also to a *controlled body diode recovery circuit* (C. B. D. R. circuit) which is used with either one or two semiconductor switches having anti-parallel diodes (either intrinsic to the switching device, or electrically connected to the switch), the circuit including a saturable inductor in series with the switching semiconductor or semiconductors, and in parallel with the saturable inductor or in parallel with a series combination of the saturable inductor and a semiconductor switch there is a recovery circuit for controlling the reverse recovery current of the antiparallel diode, the recovery circuit including a series combination of an inductor and a first diode having its forward direction opposite to the forward direction of the antiparallel diode it controls the recovery of, the inductor of the recovery circuit being dimensioned for controlled rate of increase in reverse recovery current of said antiparallel diode.

This circuit controls the reverse recovery current of a diode or of a semiconductor switch body diode. When the diode is reverse biased after carrying forward current, it takes some time to recover its blocking ability, while carriers recombine. This circuit will control the reverse current flowing during this time so that the diode and the rest of the circuit are protected from large stresses which would otherwise be caused by the huge reverse current flowing.

A method commonly used to control diode recovery current is to control (lower) the speed of the associated switching device. This method gives high losses in the switching device due to it carrying diode recovery current and output current (usually to an inductor) while in the linear region. The switching device will be in the linear region while the diode is recovering.

A second method is to use a saturable (square loop) inductor in series with the diode. This inductor blocks the reverse current flow, without controlling its rate of increase, and greatly increases the recovery time of the diode. This method also has the problem of blocking forward current flow in the time it takes the inductor to saturate for current flow in that direction. A larger V.t (volt-time) rating of saturable inductor will be required than with the C.D.R. circuit according to the present invention, as this prior known circuit does not provide a controlled rate of reverse current flow (needed to recover the diode quickly).

EP-0 351 144 A1 shows (in Figures 5 and 6) a circuit according to the introductory part of claim 1. Fig. 6 of this prior art document builds on fig.5 by including D2, C2 and D5 to recover some surplus energy stored in C2, and direct it to the output (Vout). The second addition shown in fig. 6 is for clamping of the voltage across the switch. This uses L2, R1, C1, D3 and D5. The document fails to describe D2 of fig. 6, whose purpose is to direct surplus energy from L4 into C2. D5 (which is described) directs surplus energy from C2 to the output.

There are other circuits used to limit the reverse recovery characteristics of diodes. Some of these are for specific types of converter, whereas the C.D.R. or C.B.D.R. circuit according to the present invention is simply connected in series with the main diode or semiconductor switch body diode, allowing use in any type of circuit, including those which have a series connected switching device, such as an AC chopper (line frequency power converter) and with half-bridge or full-bridge circuits.

The a.c. chopper method varies the r.m.s. voltage while maintaining the input waveform frequency and shape.

The a.c. chopper solves the problem with phase cutting controllers of line frequency harmonics and rise times, at the expense of higher cost and reduced efficiency. The novelties presented here help reduce the cost and increase efficiency of the a.c. chopper, though are not limited in use to this type of circuit.

The C.D.R. or C.B.D.R. circuit according to the present invention is designed to allow a controlled rate of increase in reverse recovery current so that the diode recovers quickly. The optimum rate of increase in reverse current for the application can be chosen. This also means the peak reverse current is also limited due to the rate of increase in reverse current and the speed of the diode.

To obtain these characteristics and the desired control of the reverse recovery current, the invention is characterized by the features of claim 1 (C.D.R.) or by the features of claim 9 (C.B.D.R.). Dependent claims define advantageous application configurations wherein the circuit according to this invention can be used.

When the diode to be recovered is required to conduct in a forward direction, the C.D.R. or C.B.D.R. circuit presents little impedance to current flow. This is because the circuit automatically provides a V.t across the saturable inductor, for forward conduction, after recovery of the diode to be recovered.

The novel controlled diode recovery circuit according to the present invention, when applied in the a.c. chopper, further reduces switching losses and device stresses, making the overall power conversion more efficient and reliable. This allows higher switching frequencies, smaller and lower rated components to be used, and higher efficiency, with significant cost savings.

The advantage of the C.B.D.R. circuit is that it allows the body diode of high speed switching semiconductors to be used at high switching frequencies, while giving low losses and low device stresses.

In other words, the C.D.R. or C.B.D.R. circuit presented here is a novel way to control the slope of the reverse recovery current of the diode, without having to control the slope of the current rise through the associated power switch, and also presenting minimum impedance or delay when the diode is required to conduct in the forward direction.

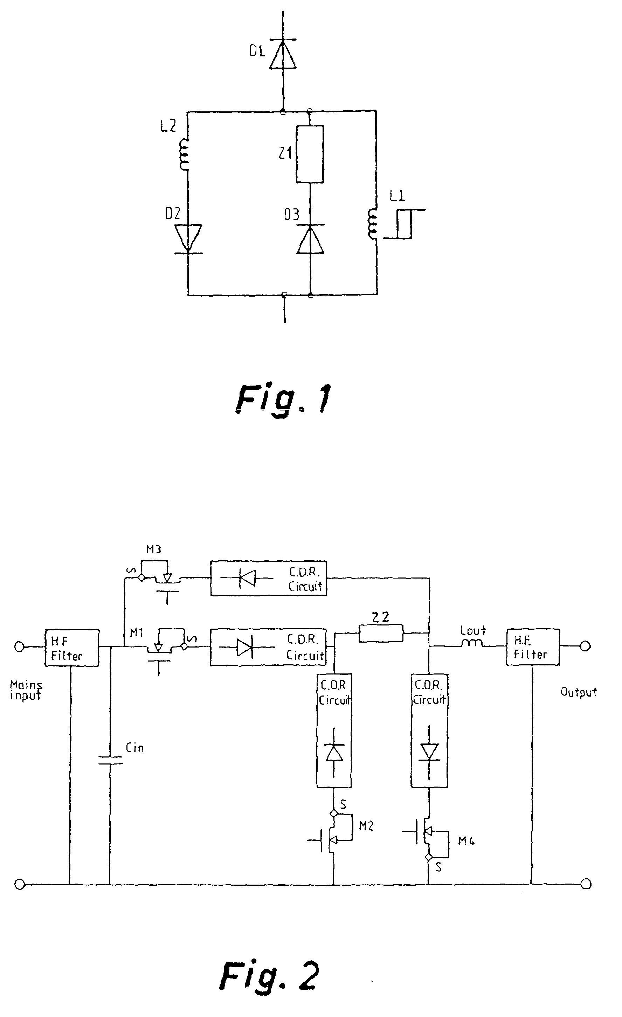

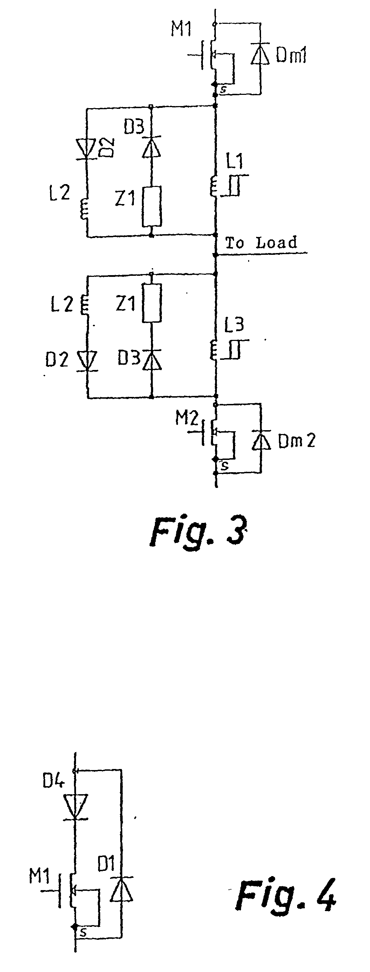

In the circuit of the present invention energy recovery is possible by making use of the energy transferred from the second inductor L2 to the impedance Z1 after recovery (see figures 1 and 3). Alternatively, this energy may be dissipated in Z1.

There are several circuit configurations wherein the C.B.D.R. circuit can be used. The first is with a single switch/body diode (such as part of Fig. 3). The second configuration is with two switches in a series combination, with the output taken from their joining point (such as a half- or full-bridge arrangement shown in Fig. 3).

Different circuit configurations of the invention and one application of use will now be described in more detail with reference to the enclosed drawing, wherein
- Figure 1: shows a circuit diagram of the controlled diode recovery (C.D.R.) circuit according to the present invention;
- Figure 2: shows a power converter (a.c. chopper) wherein the C.D.R. circuit according to figure 1 can be advantageously used.
- Figure 3: shows the controlled body diode recovery circuits (C.B.D.R.) with half/full bridge circuit configuration, and
- Figure 4: shows an alternative switch which can be used in the circuit configuration of Figure 3 or Figure 4, the switch being provided with series schottky diode and antiparallel freewheel diode.

The controlled diode recovery (C.D.R.) circuit is shown in **figure 1**. This circuit allows the corresponding power switch (such as switches M1-M4 in Fig. 2) to be turned on rapidly, without regard for the main diode D1 recovery current slope or magnitude. The circuit below D1 has the function of controlling the reverse recovery current of D1, while giving low power loss, and unhindered forward conduction of D1. L1 is a saturable inductor.

During forward conduction of D1, all the current flows through L1. L1 is saturated, and no current flows through the D2 or D3 branches. Losses are mainly due to the forward conduction losses of D1.

When the cathode of D1 is pulled high relative to the bottom rail of the circuit, D1 will not block reverse current flow until it recovers. No current will flow through the D3 branch, as it recovers almost immediately, due to no forward current previously flowing through D3. L1, which was previously carrying current from bottom to top, will block the voltage now across it until its volt-second rating is exceeded. Therefore, the only branch which will support reverse recovery current of D1 is presently the L2/D2 branch. The current flow starts at zero and increases approximately linearly due to the voltage across L2.

Eventually D1 recovers, with the peak recovery current flowing through L2/D2, and the volt-second rating of L1 not quite reached. The peak recovery current will now freewheel through the L2/D2, D3/Z1 loop, decaying as the energy is dissipated in resistance of Z1. A voltage appears across Z1 due to this current, causing L1's bottom terminal to be positive with respect to its top. This moves the state of L1 towards saturation for current flow from bottom to top. The volt-second (v.t) product required to reduce the L2 current to zero is the same as that required to saturate L1 for current flow in the main diode forward direction. Possibilities for Z1 include a single resistor, or a resistor in series with a parallel R-C. This second possibility allows fast reduction of the L2 current (and saturating of L1) while giving a smaller peak voltage drop in comparison to a single resistor.

When D1 is next required to conduct, L1 will rapidly saturate (if not already saturated) during the fall time of the top rail voltage. Some current flows through D3/Z1, before L1 fully saturates, during the rise time of the forward current through D1. When L1 saturates, it will carry all the forward conduction current, allowing D3 to recover.

It can be seen that the C.D.R. circuit adds no significant conduction losses, and reduces switching losses due to the controlled reverse recovery current of the main diode.

The overall power converter is shown in **figure 2**. The power flow does not have to be from the mains input to the output, but the rms voltage on the terminals shown as output will always be less than or equal to the voltage at the terminals shown as mains input. The circuit behaves in a similar way to a forward converter when transferring energy from the mains input to the output, but behaves in a similar way to a flyback converter when transferring energy from the output to the input. The novel configuration contains an impedance Z2 to join the two branches. The connection to output impedance Lₒᵤₜ may be taken from either side of Z2. Novel circuits to control diode reverse recovery are shown as blocks (C.D.R. Circuit) in figure 2, but are expanded in figure 1.

The switching devices shown M1-M4 are MOSFETs, but other semiconductor switching devices may be used instead. The circuits to generate the gate drives for M1-M4 are not shown. Cᵢₙ forms the last stage of the input filter, and Lₒᵤₜ forms the first stage of the output filter.

The top switching devices M1 & M3 are turned on to connect the output inductor Lₒᵤₜ to the input capacitor Cᵢₙ, or alternatively the bottom switches M2 & M4 are turned on to connect Lₒᵤₜ to ground (neutral), providing a freewheel path. This switching between top switches and bottom switches is carried out at a high frequency and a variable duty ratio. The duty ratio of top:top+bottom switch on-times scales the average voltage seen by Lₒᵤₜ at its left terminal. If the duty ratio is left constant, the output waveform will be a scaled version of the input waveform. High frequency filters may be used to prevent the switching frequency and its harmonic components from reaching the supply or load. If filtering is not required, the H.F. filters may be replaced with a short circuit from input to output, Lₒᵤₜ may be replaced by a short circuit, and Cᵢₙ may be replaced by an open circuit.

There are two branches for current flow in the circuit of figure 2. The M1-M2 branch carries current only when the current through Lₒᵤₜ flows from left to right. The M3-M4 branch carries current only when the current through Lₒᵤₜ flows from right to left. Only one switch is required to control current flow for a specific combination of input voltage polarity and output current direction, other switches being left on or off as appropriate.

The novel a.c. chopper circuit configuration of two branches (M1-M2 and M3-M4 with their associated diode circuits) joined by Z2 allows an overlap of the on-time between the top M1 & M3 and bottom M2 & M4 switches. An inductive component of Z2 prevents the large currents which would otherwise flow (if Z2 was a short-circuit) through the effective short-circuit of Cᵢₙ by M1-M4 or M2-M3 during the overlap time. Overlap of the on-times may be caused by timing errors of gate drive signals, rise/fall times of switch currents, or undesirable dv/dt turn-on of switches. One possible configuration for Z2 is an inductor and resistor in parallel, the inductor preventing large currents during overlap, and the resistor dissipating the energy stored in the inductor due to overlap of switch on-times.

It is possible to modify the a.c. chopper circuit of Fig. 2 in several ways,
(i) The connection to Lₒᵤₜ could be taken from the other side of Z2.
(ii) Z2 could be replaced by two impedances in series, with Lₒᵤₜ taken from the connection between these impedances. This would mean both halves of the circuit could have the same additional output filtering caused by the impedances. These two impedances could consist of separate inductors, or mutually coupled inductors, with or without parallel resistors.
(iii) The impedance could be an inductor and resistor in parallel, but alternatives include an inductor in parallel with series back to back zener diodes etc.

The a.c. chopper may be used in light dimmers, power supplies, motor controllers, heating controllers, voltage regulators/stabilisers or other applications requiring an a.c. input voltage to be converted to a higher or lower output voltage.

The C.D.R. circuit is not restricted to use in an a.c. chopper, but may be used to reduce switching losses and device stresses in any circuit which requires fast recovery diodes. Possible uses are in switching power supplies, light dimmers, motor controllers, heater controllers, electronic ballasts, and other power applications.

The saturable inductor, L1, has some finite inductance even when saturated. This means some energy is stored when current is flowing, causing a voltage spike across the series switch during turn-off. Provided the saturated inductance is small enough, the energy stored here will (usefully) charge the output capacitance of the switch at turn-off.

Due to an imperfect hysteresis loop, L1 will allow some reverse current flow through D1, though this will be limited. This current adds to the controlled current slope, and will increase recovery speed but gives larger peak recovery current.

**Figure 3** shows the case when the semiconductor switches M1 and M2 are used in a half- or full-bridge arrangement. The switches are connected in series, across a constant polarity supply voltage. Operation can be explained by first assuming steady state starting conditions, such that current is flowing from the load (connected at the junction of the saturable inductors L1 and L3), up through L1 and Dm1 (the body or external diode of M1). M1 drain is connected to the positive supply rail, and M2 source is connected to the negative supply rail. M2 is in the off state.

Now switch M2 is turned on. L3 was already saturated for current flow from top to bottom, so the load connection is pulled low and the load current starts to flow through L3 and M2. Since Dm1 was carrying forward current, it will not block until after its reverse recovery time. L1 will block because it was previously carrying current from bottom to top, so now comes out of saturation. Diode D3 of the top branch will block almost immediately as it was not previously carrying current. This leaves D2/L2 of the top branch as the only path to carry recovery current of Dm1. L2 (top branch) will allow a controlled rate of increase in reverse recovery current, and when Dm1 recovers, the peak recovery current now flowing in L2 (top branch) will freewheel through Z1/D3 (top branch). As the current through L2 (top branch) decays, it has a positive voltage on its bottom terminal with respect to its top, giving a positive voltage on the bottom terminal of L1 with respect to its top. This shifts the state of L1 towards saturation for current flow from bottom to top. The volt-time required to reduce the current flow through L2 (top branch) to zero is the same as that now needed to saturate L1.

When M2 turns off, the load current will flow through L1 and Dm1, with L3 being left in the saturated state for conduction from top to bottom. This is the steady state starting condition described previously.

Operation for load current flowing in the opposite direction (i.e. to the load from L1 or L3) is similar, except that Dm2 (the body or external diode of M2) is now the diode used for freewheeling, and M1 is the controlling switch. Under these conditions, L1 remains saturated for current flow from top to bottom and Dm2 recovery is controlled by the bottom branch L2/D2, Z1/D3, L3 components.

A single switch with its associated CBDR circuit, of figure 3, could be used in a circuit, as the two halves of this circuit operate independently.

There are other circuit configurations which are covered by the same inventive concept. Such configurations are:
i) when the semiconductor switches used in all arrangements described already, are used with a series connected diode D4 (usually a schottky) and an anti-parallel diode D1 for reverse conduction, connected across both the switch and the series diode (**figure 4**).
ii) when the switch source and drain connections are reversed, and all diode anode/cathodes are reversed in the previously described circuits. (Figure 3 just gives the same circuit, but figure 4 gives a circuit operating in a similar way, but with the drain connections to the saturable inductor rather than the sources).

## Claims

1. Controlled diode recovery circuit which is connected in series with the diode to be recovered, called main diode (D1) in the following, the circuit including a saturable inductor (L1) in series with the main diode (D1), and in parallel with the saturable inductor there is a series combination of a second inductor (L2) and a second diode (D2), the second inductor (L2) being dimensioned for a controlled rate of increase in reverse recovery current of said main diode (D1), and the second diode (D2) having its forward direction opposite to the forward direction of the main diode (D1) for allowing the flow of the reverse recovery current of the main diode (D1), **characterized in that** in parallel with the saturable inductor (L1) and with the series combination of the second inductor (L2) and the second diode (D2) there is a series connection of a third diode (D3) and an impedance (Z1), the third diode (D3) and the main diode (D1) having the same forward direction.

2. Circuit according to claim 1, **characterized in that** the impedance (Z1) is a resistor or a resistor in series with a parallel connection of a resistor and a capacitor.

3. Application of the controlled diode recovery circuit according to claim 1 in an AC to AC line frequency power converter having terminals for input and output and two circuit branches connected to the output terminal either directly or through an output inductor (Lₒᵤₜ) and/or an output filter, the first branch including a series connection of two semiconductor switches (M1, M2) and two diodes for allowing current flow through the output inductor (Lₒᵤₜ) in the first direction and the second branch including a series connection of two semiconductor switches (M3, M4) and two diodes for allowing current flow through the output inductor (Lₒᵤₜ) in the second direction, the diodes in each branch having mutually opposite forward directions and the semiconductor switches in each branch also having mutually opposite forward directions, one end of the output inductor (Lₒᵤₜ) having at least indirect connection to the points between the two diodes in each branch, each of said four diodes being provided with said controlled diode recovery circuit.

4. Circuit application according to claim 3, **characterized by** a second impedance (Z2), which joins the two branches such that each terminal of the second impedance (Z2) is connected at the joining point of the two diodes of only one branch.

5. Circuit application according to claim 4, **characterized in that** the output inductor (Lₒᵤₜ), output filter, or the output terminal is connected to one side of the second impedance (Z2).

6. Circuit application according to claim 4, **characterized in that** the second impedance includes two impedances in series, the output inductor (Lₒᵤₜ), output filter, or the output terminal being connected at the junction of the two impedances.

7. Circuit application according to claim 6, **characterized in that** the two impedances include two inductors, which are mutually coupled.

8. Controlled diode recovery circuit which is used with at least one semiconductor switch (M1 M2) having an antiparallel diode (Dm1, Dm2, D1) either intrinsic to the semiconductor switch or electrically connected to the switch, the circuit including a saturable inductor (L1, L3) in series with the semiconductor switch or switches, and in parallel with the saturable inductor (L1, L3) or in parallel with a series combination of the saturable inductor (L1, L3) and a semiconductor switch (M1, M2) there is a recovery circuit for controlling the reverse recovery current of the antiparallel diode (Dm1, Dm2, D1), the recovery circuit including a series combination of an inductor (L2) and a first diode (D2) having its forward direction opposite to the forward direction of the antiparallel diode it controls the recovery of (Dm1, Dm2, D1), the inductor (L2) of the recovery circuit being dimensioned for controlled rate of increase in reverse recovery current of said antiparallel diode (Dm1, Dm2, D1), **characterized in that** in parallel with the saturable inductor (L1, L3) there is a series combination of a further diode (D3) and an impedance (Z1), the further diode (D3) having its forward direction opposite to the forward direction of the first diode (D2) of the recovery circuit.

9. Circuit according to claim 8, **characterized in that** the antiparallel diode (Dm1, Dm2) is a body diode (Dm1, Dm2) of the semiconductor switch (M1, M2).

10. Circuit according to claim 8, **characterized in that** the antiparallel diode (Dm1, Dm2) is a freewheel diode (D1) connected in parallel with a series combination of the semiconductor switch (M1, M2) and a schottky diode (D4).

11. Circuit according to claim 9, **characterized by** a series combination of two semiconductor switches (M1, M2) having the same forward direction and two saturable inductors (L1, L3) between the switches, each of the saturable inductors (L1, L3) having a recovery circuit (D2, L2) in parallel with the inductor (L1, L3), and also in parallel with the inductor (L1, L3) there is a series combination of a further diode (D3) and an impedance (Z1), the further diode (D3) having its forward direction opposite to the forward direction of the first diode (D2) of the recovery circuit.

## Patentansprüche

1. Gesteuerte Dioden-Erholschaltung, die in Reihe mit der zu erholenden Diode, im folgenden Hauptdiode (D1) genannt, geschaltet ist, wobei die Schaltung eine sättigbare Induktivität (L1) in Reihe mit der Hauptdiode (D1) aufweist, und parallel zur sättigbaren Induktivität ist eine Reihenschaltung einer zweiten sättigbaren Induktivität (L2) und einer zweiten Diode (D2) vorgesehen, wobei die zweite sättigbare Induktivität (L2) entsprechend einer gesteuerten Zunahmerate des Sperr-Erholstroms der besagten Hauptdiode (D1) dimensioniert ist und die zweite Diode (D2) ihre Durchlassrichtung umgekehrt zur Durchlassrichtung der Hauptdiode (D1) hat, um den Sperr-Erholstrom der Hauptdiode (D1) steuern zu können, **dadurch gekennzeichnet, dass** parallel zur Induktivität (L1) oder der Reihenschaltung der zweiten Induktivität (L2) und der zweiten Diode (D2) eine Reihenschaltung einer dritten Diode (D3) und einer Impedanz (Z1) vorgesehen ist, wobei die dritte Diode (D3) und die Hauptdiode (D1) die gleiche Durchlassrichtung aufweisen.

2. Schaltung nach Anspruch 1, **dadurch gekennzeichnet, dass** die Impedanz (Z1) ein Widerstand oder ein Widerstand in Reihe mit einer Parallelschaltung eines Widerstands und eines Kondensators ist.

3. Anwendung der gesteuerten Dioden-Erholschaltung nach Anspruch 1 in einem WechselspannungsLeitungswandler mit Anschlüssen für Ein- und Ausgänge und zwei mit dem Ausgangsanschluss entweder direkt oder über eine Ausgangsinduktivität (Lₒᵤₜ) und/oder einen Ausgangsfilter verbundenen Schaltungszweigen, wobei der erste Zweig eine Reihenschaltung von zwei Halbleiterschaltern (M1, M2) und zwei Dioden zum Erlauben von Stromfluss durch die Ausgangsinduktivität (Lₒᵤₜ) in der ersten Richtung aufweist, und der zweite Zweig eine Reihenschaltung von zwei Halbleiterschaltern (M3, M4) und zwei Dioden zum Erlauben von Stromfluss durch die Ausgangsinduktivität (Lₒᵤₜ) in der zweiten Richtung aufweist, wobei die Dioden jedes Zweigs zueinander entgegengesetzte Durchlassrichtungen aufweisen und die Halbleiterschalter in jedem Zweig ebenso zueinander entgegengesetzte Durchlassrichtungen aufweisen, wobei ein Ende der Ausgangsinduktivität (Lₒᵤₜ) wenigstens eine indirekte Verbindung mit den Punkten zwischen den beiden Dioden in jedem Zweig hat, wobei jede der besagten vier Dioden mit der besagten gesteuerten Dioden-Erholschaltung versehen ist.

4. Schaltungsanwendung nach Anspruch 3, **gekennzeichnet durch** eine zweite Impedanz (Z2), die die beiden Zweige verbindet, so dass jeder Anschluss der zweiten Impedanz (Z2) an dem Verbindungspunkt der beiden Dioden nur eines Zweigs verbunden ist.

5. Schaltungsanwendung nach Anspruch 4, **dadurch gekennzeichnet, dass** die Ausgangsinduktivität (Lₒᵤₜ), der Ausgangsfilter oder der Ausgangsanschluss an einer Seite der zweiten Impedanz angeschlossen ist.

6. Schaltungsanwendung nach Anspruch 4, **dadurch gekennzeichnet, dass** die zweite Impedanz zwei Impedanzen in Reihe aufweist, wobei die Ausgangsinduktivität (Lₒᵤₜ), der Ausgangsfilter oder der Ausgangsanschluss am Verbindungspunkt der beiden Impedanzen angeschlossen sind.

7. Schaltungsanwendung nach Anspruch 6, **dadurch gekennzeichnet, dass** die beiden Impedanzen zwei Induktivitäten aufweisen, die gegenseitig gekoppelt sind.

8. Gesteuerte Dioden-Erholschaltung, die mit wenigstens einem Halbleiterschalter (M1, M2) mit einer antiparallelen Diode (Dm1, Dm2, D1), entweder innerhalb des Halbleiterschalters oder mit dem Schalter elektrisch verbunden, verwendet wird, wobei die Schaltung eine sättigbare Induktivität (L1, L3) in Reihe mit dem Halbleiterschalter oder den Halbleiterschaltern aufweist, und parallel zur sättigbaren Induktivität (L1, L3) oder parallel zu einer Reihenschaltung der sättigbaren Induktivität (L1, L3) und einem Halbleiterschalter (M1, M2) ist eine Erholschaltung zur Steuerung des Sperr-Erholstroms der antiparallelen Diode (Dm1, Dm2, D1) vorgesehen, wobei die Erholschaltung eine Reihenschaltung einer Induktivität (L2) und einer ersten Diode (D2) mit der Durchlassrichtung entgegengesetzt zur Durchlassrichtung der antiparallelen Diode (Dm1, Dm2, D1), deren Erholung sie steuert, aufweist, wobei die Induktivität (L2) der Erholschaltung entsprechend einer gesteuerten Zunahmerate des Sperr-Erholstroms der besagten antiparallelen Hauptdiode (Dm1, Dm2, D1) dimensioniert ist, **dadurch gekennzeichnet, dass** parallel zur sättigbaren Induktivität (L1, L3) eine Reihenschaltung einer weiteren Diode (D3) und einer Impedanz (Z1) vorgesehen ist, wobei die weitere Diode (D3) ihre Durchlassrichtung umgekehrt zur Durchlassrichtung der ersten Diode (D2) der Erholschaltung hat.

9. Schaltung nach Anspruch 8, **dadurch gekennzeichnet, dass** die antiparallele Diode (Dm1, Dm2) eine Body-Diode (Dm1, Dm2) des zugehörigen Halbleiterschalters (M1, M2) ist.

10. Schaltung nach Anspruch 8, **dadurch gekennzeichnet, dass** die antiparallele Diode (Dm1, Dm2) eine Freilauf-Diode parallel zu einer Reihenschaltung des Halbleiterschalters (M1, M2) und einer Schottky-Diode (D4) ist.

11. Schaltung nach Anspruch 9, **gekennzeichnet durch** eine Reihenschaltung von zwei Halbleiterschaltern (M1, M2) mit der gleichen Durchlassrichtung und zwei sättigbaren Induktivitäten (L1, L3) zwischen den beiden Schaltern, wobei jede der sättigbaren Induktivitäten (L1, L3) eine Erholschaltung (D2, L2) parallel zur Induktivität (L1, L3) hat, und ebenfalls parallel zur Induktivität (L1, L3) befindet sich eine Reihenschaltung einer weiteren Diode (D3) und einer Impedanz (Z1), wobei die weitere Diode (D3) ihre Durchlassrichtung umgekehrt zur Durchlassrichtung der ersten Diode (D2) der Erholschaltung hat.

## Revendications

1. Circuit commandé de récupération de diode, qui est monté en série avec la diode à rétablir, dénommée diode principale (D1) ci-après, le circuit comprenant une bobine d'inductance saturable (L1) montée en série avec la diode principale (D1), et dans lequel il est prévu, en parallèle à la bobine d'inductance saturable, une combinaison série constituée d'une deuxième bobine d'inductance (L2) et d'une deuxième diode (D2), la deuxième bobine d'inductance (L2) étant dimensionnée pour une vitesse commandée d'augmentation du courant de recouvrement inverse de ladite diode principale (D1), et la deuxième diode (D2) ayant son sens direct opposé au sens direct de la diode principale (D1) afin de permettre le passage du courant de recouvrement inverse de la diode principale (D1), **caractérisé en ce qu'**il est prévu, en parallèle à la bobine d'inductance saturable (L1) et à la combinaison série de la deuxième bobine d'inductance (L2) et de la deuxième diode (D2), un montage en série constitué d'une troisième diode (D3) et d'un élément d'impédance (Z1), la troisième diode (D3) et la diode principale (D1) ayant le même sens direct.

2. Circuit selon la revendication 1, **caractérisé en ce que** l'élément d'impédance (Z1) est une résistance, ou une résistance en série avec un montage en parallèle constitué d'une résistance et d'un condensateur.

3. Application du circuit commandé de récupération de diode, selon la revendication 1, à un convertisseur de courant alternatif/alternatif à la fréquence du secteur, présentant des bornes pour l'entrée et pour la sortie, et deux branches de circuit qui sont reliées à la borne de sortie soit directement soit par l'intermédiaire d'une bobine d'inductance de sortie (Lₒᵤₜ) et/ou d'un filtre de sortie, la première branche comprenant un montage en série de deux commutateurs à semi-conducteur (M1, M2) et de deux diodes afin de permettre le passage de courant par l'intermédiaire de la bobine d'inductance de sortie (Lₒᵤₜ) dans le premier sens, et la deuxième branche comprenant un montage en série de deux commutateurs à semi-conducteur (M3, M4) et de deux diodes afin de permettre le passage de courant par l'intermédiaire de la bobine d'inductance de sortie (Lₒᵤₜ) dans le deuxième sens, les diodes de chaque branche ayant des sens directs mutuellement opposés et les commutateurs à semi-conducteur de chaque branche ayant également des sens directs mutuellement opposés, une extrémité de la bobine d'inductance de sortie (Lₒᵤₜ) comportant au moins une connexion indirecte avec les points situés entre les deux diodes de chaque branche, chacune desdites quatre diodes étant pourvue dudit circuit de recouvrement commandé de diode.

4. Application du circuit selon la revendication 3, **caractérisée par** un deuxième élément d'impédance (Z2), qui relie les deux branches de telle sorte que chaque borne du deuxième élément d'impédance (Z2) soit reliée au point de connexion des deux diodes d'une seule branche.

5. Application du circuit selon la revendication 4, **caractérisée en ce que** la bobine d'inductance de sortie (Lₒᵤₜ), le filtre de sortie ou la borne de sortie sont reliés à un côté du deuxième élément d'impédance (Z2).

6. Application du circuit selon la revendication 4, **caractérisée en ce que** le deuxième élément d'impédance comprend deux éléments d'impédance en série, la bobine d'inductance de sortie (Lₒᵤₜ), le filtre de sortie ou la borne de sortie étant reliés au niveau de la connexion des deux éléments d'impédance.

7. Application du circuit selon la revendication 6, **caractérisée en ce que** les deux éléments d'impédance comprennent deux bobines d'inductance, qui sont mutuellement couplées.

8. Circuit commandé de récupération de diode, qui est utilisé avec au moins un commutateur à semi-conducteur (M1, M2), avec une diode montée tête-bêche (Dm1, Dm2, D1) soit de manière intrinsèque au commutateur à semi-conducteur soit électriquement reliée au commutateur, le circuit comprenant une bobine d'inductance saturable (L1, L3) montée en série avec le ou les commutateur(s) à semi-conducteur, et dans lequel il est prévu, en parallèle à la bobine d'inductance saturable (L1, L3) ou en parallèle à une combinaison série comportant la bobine d'inductance saturable (L1, L3) et un commutateur à semi-conducteur (M1, M2), un circuit de récupération servant à commander le courant de recouvrement inverse de la diode montée tête-bêche (Dm1, Dm2, D1), le circuit de récupération comportant une combinaison série d'une bobine d'inductance (L2) et d'une première diode (D2) dont le sens direct est opposé au sens direct de la diode montée tête-bêche (Dm1, Dm2, D1) dont elle commande la récupération, la bobine d'inductance (L2) du circuit de récupération étant dimensionnée pour une vitesse commandée d'augmentation du courant de recouvrement inverse de ladite diode montée tête-bêche (Dm1, Dm2, D1), **caractérisé en ce qu'**il est en outre prévu, en parallèle à la bobine d'inductance saturable (L1, L3), une combinaison série constituée d'une diode (D3) supplémentaire et d'un élément d'impédance (Z1), ladite diode (D3) supplémentaire ayant son sens direct opposé au sens direct de la première diode (D2) du circuit de récupération.

9. Circuit selon la revendication 8, **caractérisé en ce que** la diode montée tête-bêche (Dm1, Dm2) est une diode de corps (Dm1, Dm2) du commutateur à semi-conducteur (M1, M2).

10. Circuit selon la revendication 8, **caractérisé en ce que** la diode montée tête-bêche (Dm1, Dm2) est une diode de roue libre (D1), montée en parallèle à une combinaison série constituée du commutateur à semi-conducteur (M1, M2) et d'une diode de Schottky (D4).

11. Circuit selon la revendication 9, **caractérisé par** une combinaison série de deux commutateurs à semi-conducteur (M1, M2) ayant le même sens direct, et de deux bobines d'inductance saturables (L1, L3) situées entre les commutateurs, chacune des bobines d'inductance saturables (L1, L3) comportant un circuit de récupération (D2, L2) en parallèle à la bobine d'inductance (L1/ L3) et dans lequel il est prévu, également en parallèle à la bobine d'inductance (L1, L3), une combinaison série constituée d'une diode (D3) supplémentaire et d'un élément d'impédance (Z1), ladite diode supplémentaire (D3), ayant son sens direct opposé au sens direct de la première diode (D2) du circuit de récupération.
